# EUROPEAN PATENT APPLICATION

(11) **EP 4 636 407 A1**
(43) Date of publication of application: **22.10.2025**
(21) Application number: 25166206.0
(22) Date of filing: 26.03.2025
(51) Int. Cl.: G01R 15/18

(54) **CLAMP AMMETER AND CURRENT MEASUREMENT METHOD**

(30) Priority: 19.04.2024 JP 2024068688
(71) Applicant: Yokogawa Electric Corporation, Tokyo 180-8750 (JP); Yokogawa Test & Measurement Corporation, Hachioji-shi, Tokyo 192-8566 (JP)
(72) Inventor: MURAKAMI, Kenji, Hachioji-shi, Tokyo, 192-8566 (JP); KAWAI, Nobuaki, Hachioji-shi, Tokyo, 192-8566 (JP); FU, Bo, Hachioji-shi, Tokyo, 192-8566 (JP)
(74) Representative: Stöckeler, Ferdinand

(57) **Abstract**

The clamp ammeter includes a clamp and a slim grip. The clamp has a base and a movable portion which is movable relative to the base. The clamp operates, by the movement of the movable portion, between a closed state and an open state. In front view, a longitudinal direction of the clamp in the closed state forms an angle of more than 45° and equal to or less than a right angle with respect to a longitudinal direction of the grip. The base extends from the grip to a distal end portion of the clamp in a lateral direction of the clamp in the closed state. The movable portion extends from the grip to the distal end portion of the clamp, and makes the clamp from the closed state to the open state by the movement to a proximal side.

## Description

### TECHNICAL FIELD

The present disclosure relates to a clamp ammeter and a current measurement method.

### BACKGROUND

Clamp ammeters having clamps and slim grips connected to the clamps are known. For example, see Patent Literatures (PTLs) 1 to 2 and Non-patent Literature (NPL) 1.

### CITATION LIST

### Patent Literature

PTL 1: JP Design Registration No. 1434290
PTL 2: JP 2020-8567 A

### Non-patent Literature

NPL 1: Clamp Meter DCM600DR (Sanwa Electric Instrument Co., Ltd.) catalog (https://www.sanwa-meter.co.jp/japan/products/clamp/dem60 0dr.html)

### SUMMARY

It would be helpful to provide a clamp ammeter and a current measurement method that are superior in workability in confined space.

An aspect of the present disclosure is as follows.
[1] A clamp ammeter including:
   a clamp; and
   a slim grip connected to the clamp,
   wherein
   the clamp has a base that is integral with the grip, and a movable portion that is configured to be movable relative to the base, the clamp is configured to operate, by the movement of the movable portion, between a closed state in which the clamp takes the shape of a slim loop in front view and an open state in which the clamp takes the shape of a non-loop in the front view,
   in the front view, a longitudinal direction of the clamp in the closed state forms an angle of more than 45° and equal to or less than a right angle with respect to a longitudinal direction of the grip,
   the base extends from the grip to a distal end portion of the clamp in a lateral direction of the clamp in the closed state, and
   the movable portion extends from the grip to the distal end portion of the clamp, and is configured to make the clamp from the closed state to the open state by the movement to a proximal side.
[2] The clamp ammeter according to [1], wherein in the front view, the angle that the longitudinal direction of the clamp in the closed state forms with respect to the longitudinal direction of the grip is a right angle.
[3] The clamp ammeter according to [1] or [2], wherein the clamp has a pair of straight portions and a pair of curved portions, the pair of straight portions faces each other in the lateral direction of the clamp and each extends straight in the longitudinal direction of the clamp, and the pair of curved portions faces each other in the longitudinal direction of the clamp and is each curved so as to protrude outward in a radial direction of the clamp.
[4] The clamp ammeter according to [3], wherein the curved portions are each curved semicircularly.
[5] The clamp ammeter according to [3] or [4], wherein
   the base of the clamp extends from a grip-side end portion to a non-grip-side end portion, the grip-side end portion is connected integrally with the grip and is located at a grip-side interface between one of the curved portions and one of the straight portions, and the non-grip-side end portion is located at a non-grip-side interface between the other of the curved portions and the other of the straight portions,
   the movable portion of the clamp extends from an unopenable-side end portion located at the grip-side interface to an openable-side end portion located at the non-grip-side interface, and the movable portion of the clamp is connected to the grip so as to be rotatable, as the movement, with respect to the base in the front view, and
   the clamp can pass a measurement target between the non-grip-side end portion of the base and the openable-side end portion of the movable portion in the open state.
[6] The clamp ammeter according to [5], further including a trigger that is configured to cause the movable portion of the clamp to rotate, as the movement, when the grip is grasped and pushed in.
[7] The clamp ammeter according to any one of [1] to [6], wherein in the closed state, the clamp accommodates three wires being a measurement target, side by side along the longitudinal direction of the clamp.
[8] The clamp ammeter according to any one of [1] to [7], wherein the outer diameter of the clamp in the lateral direction is equal to or less than 64 mm.
[9] The clamp ammeter according to any one of [1] to [8], configured to measure a leakage current of an alternating current power supply facility.
[10] A current measurement method using the clamp ammeter according to any one of [1] to [9], the current measurement method including:
   in a distribution switchboard in which a main wiring and a branch wiring are arranged, measuring a current by arranging the main wiring being a measurement target in the clamp of the clamp ammeter.
[11] The current measurement method according to [10], wherein the main wiring is three wires corresponding to a three-phase power supply facility or a single-phase power supply facility.

According to the present disclosure, it is possible to provide the clamp ammeter and the current measurement method that are superior in workability in confined space.

### BRIEF DESCRIPTION OF THE DRAWINGS

In the accompanying drawings:
FIG. 1 is a front view illustrating a closed state and an open state of a clamp of a clamp ammeter according to an embodiment of the present disclosure;
FIG. 2 is a front view illustrating a state of accommodating three wires in the clamp of the clamp ammeter illustrated in FIG. 1; and
FIG. 3 is an explanatory view that explains current measurement using the clamp ammeter illustrated in FIG. 1, in a distribution switchboard in which a main wiring and branch wirings are arranged.

### DETAILED DESCRIPTION

An embodiment of the present disclosure will be exemplarily described below in detail with reference to the drawings.

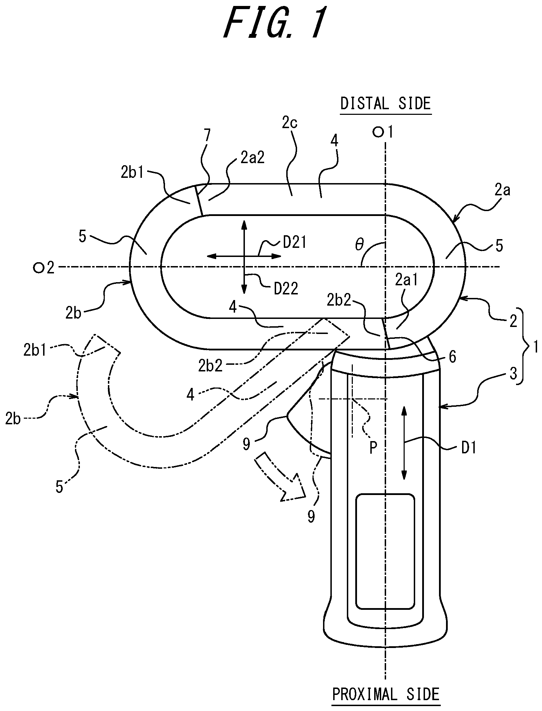

As illustrated in FIG. 1, a clamp ammeter 1 according to the embodiment of the present disclosure has a clamp 2 and a slim grip 3 connected to the clamp 2. The clamp 2 has a base 2a that is integral with the grip 3, and a movable portion 2b that is movable relative to the base 2a. The clamp 2 operates, by the movement of the movable portion 2b, between a closed state, in which the clamp 2 takes the shape of a slim loop in the front view, and an open state, in which the clamp 2 takes the shape of a non-loop in the front view. In the front view, a longitudinal direction D21 of the clamp 2 in the closed state forms an angle θ (a right angle in this embodiment) of more than 45° and equal to or less than a right angle with respect to a longitudinal direction D1 of the grip 3. The base 2a extends from the grip 3 to a distal end portion 2c of the clamp 2 in a lateral direction D22 of the clamp 2 in the closed state. The movable portion 2b extends from the grip 3 to the distal end portion 2c of the clamp 2, and makes the clamp 2 from the closed state to the open state by the above-described movement to a proximal side. Note that, the distal side refers to a distal side when a user grasps the grip 3, and the proximal side refers to the opposite side. The angle θ that the longitudinal direction D21 of the clamp 2 in the closed state forms with respect to the longitudinal direction D1 of the grip 3 refers to an angle θ that a central axis O2 extending in the longitudinal direction D21 of the clamp 2 in the closed state forms with respect to a central axis O1 extending in the longitudinal direction D1 of the grip 3.

The clamp 2 has a pair of straight portions 4, which faces each other in the lateral direction D22 of the clamp 2 and each extends straight in the longitudinal direction D21 of the clamp 2, and a pair of curved portions 5, which faces each other in the longitudinal direction D21 of the clamp 2 and is each curved so as to protrude outward in a radial direction of the clamp 2 (semicircularly in this embodiment).

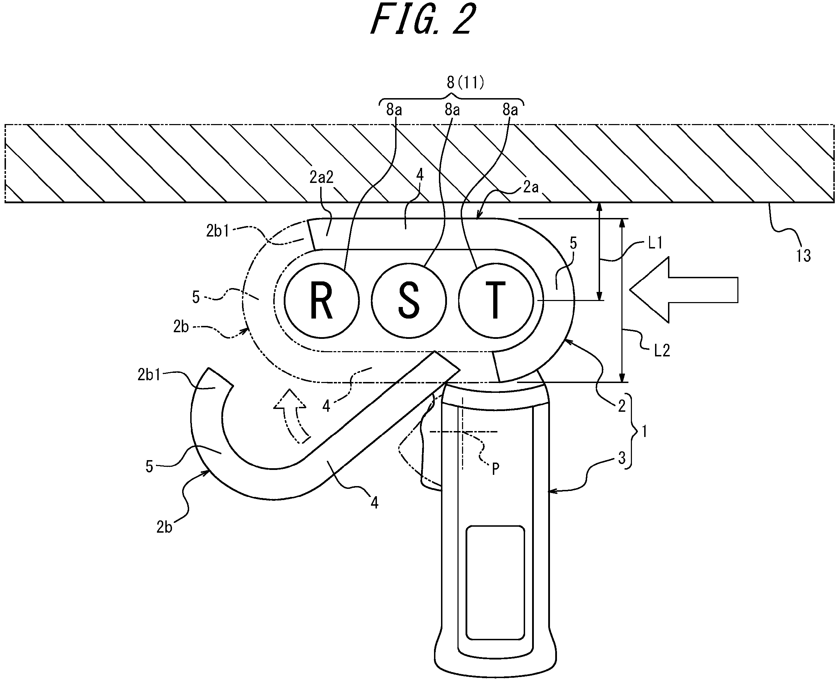

The base 2a of the clamp 2 extends from a grip-side end portion 2a1, which is connected integrally with the grip 3 and is located at a grip-side interface 6 between one of the curved portions 5 and one of the straight portions 4, to a non-grip-side end portion 2a2, which is located at a non-grip-side interface 7 between the other of the curved portions 5 and the other of the straight portions 4. The movable portion 2b of the clamp 2 extends from an unopenable-side end portion 2b2, which is located at the grip-side interface 6, to an openable-side end portion 2b1, which is located at the non-grip-side interface 7. The movable portion 2b is connected to the grip 3 so as to be rotatable around a rotation axis P, as the above-described movement, with respect to the base 2a in the front view. As illustrated in FIG. 2, the clamp 2 can pass a measurement target 8 between the non-grip-side end portion 2a2 of the base 2a and the openable-side end portion 2b1 of the movable portion 2b in the open state. In this embodiment, the measurement target 8 is three wires 8a. In the open state, the clamp 2 can pass the wires 8a one by one between the non-grip-side end portion 2a2 of the base 2a and the openable-side end portion 2b1 of the movable portion 2b.

The clamp ammeter 1 has a trigger 9, which causes the movable portion 2b of the clamp 2 to rotate, as the above-described movement, when the grip 3 is grasped and pushed in. The clamp 2 comes to the open state when the trigger 9 is pushed in, and to the closed state when the push-in operation is released.

In the closed state, the clamp 2 accommodates the three wires 8a, which are the measurement target 8, side by side along the longitudinal direction D21 of the clamp 2.

The clamp ammeter 1 is composed of a current transformer (CT) that measures a current flowing through the measurement target 8 in the clamp 2 in the closed state, using a magnetic circuit formed by the clamp 2 in the closed state. The clamp ammeter 1 adopts, for example, a winding method, a Hall element method, or other methods.

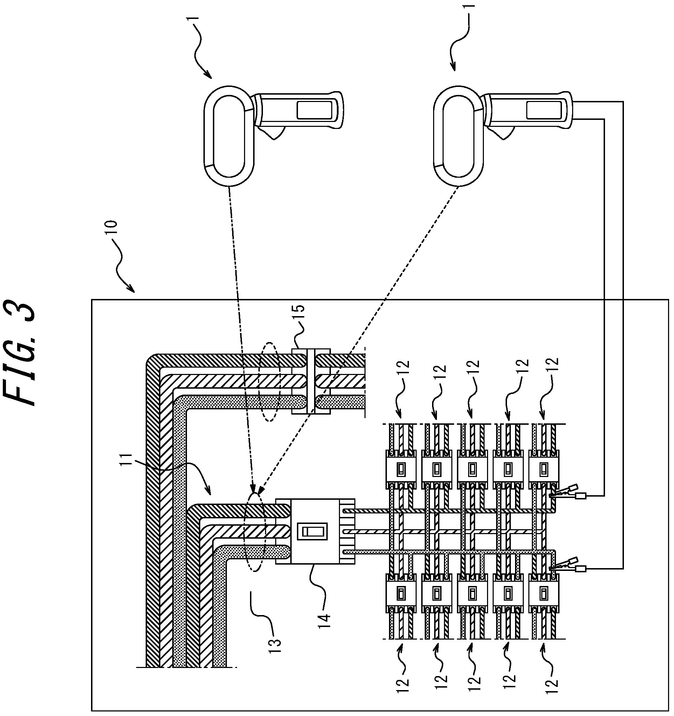

The clamp ammeter 1 can easily pass one or more wirings, especially three wirings (wires 8a), through the clamp 2 in confined space such as the inside of a distribution switchboard 10, to measure a current flowing through the wirings with high accuracy. In particular, as indicated by the arrow with the chain double-dashed line in FIG. 3, in the distribution switchboard 10 in which a main wiring 11 and branch wirings 12 are arranged, the clamp ammeter 1 is suitable for measuring a current, especially a leakage current in an alternating current power supply facility, by arranging, in the clamp 2, the three wires 8a (R-, S-, and T-phase wires corresponding to a three-phase power supply facility, in this embodiment) corresponding to a three-phase power supply facility or a single-phase power supply facility, as the main wiring 11, which are the measurement target 8.

The leakage current may be a leakage current I₀, as indicated by the arrow with the chain double-dashed line in FIG. 3, or may be an effective leakage current I₀ᵣ, as indicated by the arrow with the broken line in FIG. 3. In the case of measuring the leakage current, it is more efficient to measure the main wiring 11 first and then measure each branch wiring 12 only when a leakage is detected, rather than measuring a current of each branch wiring 12, which branches off from the main wiring 11, from the beginning.

In the case of three-wire main wiring 11 for the three-phase power supply facility or the like, each of the three wires 8a is hard and difficult to move compared to the branch wirings 12, and moreover, due to a short distance from a wall surface 13 of the distribution switchboard 10, it is difficult to use a conventional ammeter with a circular or square clamp. The three wires 8a cannot be arranged in the circular clamp because the clamp interferes with the wall surface 13 of the distribution switchboard 10. The three wires 8a can be arranged in the square clamp, but the three wires 8a in the clamp are misaligned from the center of the clamp, which makes it difficult to ensure measurement accuracy required for measuring the leakage current. In this embodiment, since the clamp 2 takes the shape of a slim loop in the closed state, as illustrated in FIG. 2, it is possible to arrange the three wires 8a at the center of the clamp 2, with avoiding interference with the wall surface 13.

In particular, as illustrated in FIG. 3, in the case of wiring that branches off at a JIS-compliant circuit breaker 14 (JIS C 8201-2-1 Annex JC, JIS-compliant circuit breaker 14 for lighting distribution switchboards), it is preferable to measure the main wiring 11 at a position immediately before the branch (for example, the position indicated by the ellipse of the chain double-dashed line in FIG. 3) adjacent to the circuit breaker 14, but at this position, the distance L1 from the wall surface 13 to the center of the main wiring 11 is only 32 mm. In this regard, the outer diameter L2 of the clamp 2 in the lateral direction D22 according to this embodiment is not particularly limited, but is preferably equal to or less than 64 mm from the viewpoint of being compatible with the JIS-compliant circuit breaker 14. Note that, when there is a terminal block 15 connected to the main wiring 11 in the distribution switchboard 10, the main wiring 11 may be measured at a position adjacent to the terminal block 15 (for example, at the position indicated by the ellipse of the broken line in FIG. 3). The distribution switchboard 10 may be configured to arrange the terminal block 15, instead of the circuit breaker 14. In this case, the main wiring 11 is preferably measured at a position that is adjacent to the terminal block 15 and immediately before the branch.

The three wires 8a can be arranged in the clamp 2, by moving the distal end portion 2c (the straight portion 4 of the base 2a) of the clamp 2 in the open state, as indicated by the solid lines in FIG. 2, toward the wires 8a along the wall surface 13 with the rod-shaped grip 3 being grasped, passing the three wires 8a sequentially between the non-grip-side end portion 2a2 of the base 2a and the openable-side end portion 2b1 of the movable portion 2b, and returning the clamp 2 to the closed state as indicated by the chain double-dashed lines in FIG. 2. At this time, as illustrated in FIG. 1, since the angle θ that the longitudinal direction D21 of the clamp 2 in the closed state forms with respect to the longitudinal direction D1 of the grip 3 is more than 45° and equal to or less than a right angle, the center of gravity of the clamp 2, which is large and heavy and not allowed to be touched directly, is brought closer to the grip 3, so the force required for work performed with the grip 3 being held can be greatly reduced. In addition, the grip 3 is farther from the wall surface 13 than when the above-described angle θ is equal to or less than 45°, thus making it easier to perform a series of operations for arranging the three wires 8a in the clamp 2. Therefore, safe work can be achieved with good operability.

The embodiment of the present disclosure has been described above, but the present disclosure is not limited to the embodiment described above. The embodiment described above can be modified variously within the bounds of not deviating from the gist of the present disclosure.

For example, the clamp ammeter 1 may be configured to measure a current other than the leakage current. The clamp ammeter 1 may also be configured to measure wirings other than 3-wire wirings, such as 2-wire wirings.

## Claims

1. A clamp ammeter comprising:
a clamp; and
a slim grip connected to the clamp,
wherein
the clamp has a base that is integral with the grip, and a movable portion that is configured to be movable relative to the base, the clamp is configured to operate, by the movement of the movable portion, between a closed state in which the clamp takes a shape of a slim loop in front view and an open state in which the clamp takes a shape of a non-loop in the front view,
in the front view, a longitudinal direction of the clamp in the closed state forms an angle of more than 45° and equal to or less than a right angle with respect to a longitudinal direction of the grip,
the base extends from the grip to a distal end portion of the clamp in a lateral direction of the clamp in the closed state, and
the movable portion extends from the grip to the distal end portion of the clamp, and is configured to make the clamp from the closed state to the open state by the movement to a proximal side.

2. The clamp ammeter according to claim 1, wherein in the front view, the angle that the longitudinal direction of the clamp in the closed state forms with respect to the longitudinal direction of the grip is a right angle.

3. The clamp ammeter according to claim 1, wherein the clamp has a pair of straight portions and a pair of curved portions, the pair of straight portions faces each other in the lateral direction of the clamp and each extends straight in the longitudinal direction of the clamp, and the pair of curved portions faces each other in the longitudinal direction of the clamp and is each curved so as to protrude outward in a radial direction of the clamp.

4. The clamp ammeter according to claim 3, wherein the curved portions are each curved semicircularly.

5. The clamp ammeter according to claim 3, wherein
the base of the clamp extends from a grip-side end portion to a non-grip-side end portion, the grip-side end portion is connected integrally with the grip and is located at a grip-side interface between one of the curved portions and one of the straight portions, and the non-grip-side end portion is located at a non-grip-side interface between the other of the curved portions and the other of the straight portions,
the movable portion of the clamp extends from an unopenable-side end portion located at the grip-side interface to an openable-side end portion located at the non-grip-side interface, and the movable portion of the clamp is connected to the grip so as to be rotatable, as the movement, with respect to the base in the front view, and
the clamp can pass a measurement target between the non-grip-side end portion of the base and the openable-side end portion of the movable portion in the open state.

6. The clamp ammeter according to claim 5, further comprising a trigger that is configured to cause the movable portion of the clamp to rotate, as the movement, when the grip is grasped and pushed in.

7. The clamp ammeter according to claim 1, wherein in the closed state, the clamp accommodates three wires being a measurement target, side by side along the longitudinal direction of the clamp.

8. The clamp ammeter according to claim 1, wherein an outer diameter of the clamp in the lateral direction is equal to or less than 64 mm.

9. The clamp ammeter according to claim 1, configured to measure a leakage current of an alternating current power supply facility.

10. A current measurement method using the clamp ammeter according to any one of claims 1 to 9, the current measurement method comprising:
in a distribution switchboard in which a main wiring and a branch wiring are arranged, measuring a current by arranging the main wiring being a measurement target in the clamp of the clamp ammeter.

11. The current measurement method according to claim 10, wherein the main wiring is three wires corresponding to a three-phase power supply facility or a single-phase power supply facility.
